Europäisches Patentamt

European Patent Office

Office européen des brevets

(11) Veröffentlichungsnummer: **0 408 970 A2**

(12) **EUROPÄISCHE PATENTANMELDUNG**

(21) Anmeldenummer: **90112616.9**

(22) Anmeldetag: **02.07.90**

(51) Int. Cl.⁵: **G01R 31/28**

(30) Priorität: **18.07.89 DE 3923764**

(43) Veröffentlichungstag der Anmeldung:
**23.01.91 Patentblatt 91/04**

(84) Benannte Vertragsstaaten:
**BE DE FR GB IT NL**

(71) Anmelder: **Siemens Aktiengesellschaft**
**Wittelsbacherplatz 2**
**D-8000 München 2(DE)**

(72) Erfinder: **Glunz, Wolfgang, Dipl.-Ing.**
**Josef-Maria-Lutz-Anger 16**
**D-8000 München 83(DE)**
Erfinder: **Armaos, Jean, Dr.-Ing.**
**Hildeboldstasse 5**
**D-8000 München 40(DE)**
Erfinder: **Hirzer, Josef, Dipl.-Ing.**
**Senftlstrasse 4**
**D-8000 München 90(DE)**

(54) **Schaltungsanordnung zur Zufuhr und Abnahme von Testsignalen bei der Prüfung eines analoge und digitale Schaltkreise aufweisenden Bausteins.**

㊼ Zur getrennten Prüfung der analogen Schaltkreise und der digitalen Schaltkreise werden in die Leitungen, die die analogen und digitalen Schaltkreise miteinander verbinden, Trennzellen (TZ) eingefügt, durch die diese Leitungen (VL1, VL2) unterbrechbar sind. Die Zufuhr der Testsignale zu den digitalen Schaltkreisen (DBL) bzw. zu den analogen Schaltkreisen (ABL) kann ebenfalls über die Trennzellen (TZ) erfolgen. Dazu können die Trennzellen (TZ) zu einem Schieberegister zusammengeschaltet werden, dem über äußere Anschlüsse (PIN) Testsignale zugeführt werden bzw. von dem von den Schaltkreisen abgegebene Testsignale zu einem äußeren Anschluß (PN) übertragen werden. Weiterhin ist es möglich, daß die Trennzellen (TZ) unabhängig voneinander im Parallelbetrieb arbeiten und dabei in den Trennzellen gespeicherte Testsignale den Schaltkreisen (ABL, DBL) zuführen bzw. im parallelen Betrieb von diesen Schaltkreisen ab gegebene Testsignale übernehmen. Trennzellen, die mit den analogen Schaltkreisen (ABL) verbunden sind, weisen eine Ausgangsstufe auf, die sicherstellt, daß an den Eingängen der analogen Schaltkreise im Schiebebetrieb keine Änderungen auftreten. Weiterhin ist es möglich, den analogen Schaltkreisen (ABL) im Testbetrieb die Testsignale parallel von äußeren Anschlüssen (PIN), die im Normalbetrieb mit den digitalen Schaltkreisen (DBL) verbunden sind, direkt zuzuführen. Dazu können Testmultiplexer (TMUX) vorgesehen sein. Die Aufteilung der Schaltkreise in einen digitalen Block (DBL) und einen analogen Block (ABL) ist deswegen zweckmäßig, da dann die Entwicklung der zu verwendenden Prüfprogramme wesentlich erleichtert wird.

FIG 2

# SCHALTUNGSANORDNUNG ZUR ZUFUHR UND ABNAHME VON TESTSIGNALEN BEI DER PRÜFUNG EINES ANALOGE UND DIGITALE SCHALTKREISE AUFWEISENDEN BAUSTEINS

Die Erfindung bezieht sich auf eine Schaltungsanordnung zur Zufuhr und Abnahme von Testsignalen bei der Prüfung eines analoge und digitale Schaltkreise aufweisenden Bausteins.

Aus Informatik Forschung und Entwicklung 1989 (4): S. 25-36 ist bekannt, die Erstellung von Prüfprogrammen für Bausteine, die analoge und digitale Schaltkreise aufweisen, dadurch zu erleichtern, daß im Testbetrieb die digitalen Schaltkreise in einen digitalen Block und die analogen Schaltkreise in einem analogen Block zusammengefaßt werden und die Verbindungen zwischen den analogen Schaltkreisen und digitalen Schaltkreisen aufgetrennt werden. Dazu werden in die Leitungen zwschen den digitalen Schaltkreisen und den analogen Schaltkreisen sog. Trennzellen eingefügt, die im Normalbetrieb die Verbindung herstellen, im Testbetrieb dagegen die Verbindung auftrennen und damit eine getrennte Prüfung des digitalen Blockes und des analogen Blockes ermöglichen. Die Prüfprogramme müssen somit nur für die Prüfung des Analogblockes bzw. des Digitalblockes geschrieben werden. Die Zufuhr von Testsignalen zu dem Analogblock bzw. Digitalblock und die Abnahme der aufgrund der zugeführten Testsignale von diesen Blöcken abgegebenen Antwortsignale, im folgenden ebenfalls Testsignale genannt, kann ebenfalls über die Trennzellen erfolgen. Dabei können die Trennzellen im Testbetrieb von den Blöcken abgegebene Testsignale speichern bzw. sie können als Schieberegister zusammengeschaltet werden und in dieser Betriebsart können die Testsignale aus dem zu testenden Baustein herausgeholt werden bzw. Testsignale hineingeschoben werden.

Die der Erfindung zugrundeliegende Aufgabe besteht darin, eine besonders einfache Schaltungsanordnung zur Zufuhr und Abnahme von Testsignalen bei derartigen Bausteinen anzugeben, die die eingangs angegebenen Prinzipien realisieren. Diese Aufgabe wird bei einer Schaltungsanordnung der angegebenen Art gemäß den in Anspruch 1 angegebenen Merkmalen gelöst.

Mit derart aufgebauten Trennzellen ist es somit möglich, im Normalbetrieb die die analogen Schaltkreise und digitalen Schaltkreise miteinander verbindenden Leitungen zu schliessen, ohne daß die Funktion durch die Trennzelle, abgesehen von einer geringen Signalverzögerung, beeinträchtigt wird. Im Testbetrieb dagegen sind diese Verbindungen aufgetrennt und über die Trennzellen kann sowohl der Digitalblock als auch der Analogblock mit Testsignalen versorgt werden bzw. die von den Blöcken abgegebenen Testsignale nach außen geführt werden. Bei der Übernahme und Übergabe der Testsignale arbeiten die Trennzellen parallel, bei der Weitergabe der Testsignale zu äußeren Anschlüssen des Bausteins bzw. bei der Übernahme von Testsignalen von äußeren Anschlüssen des Bausteins arbeiten die Trennzellen im Schiebebetrieb. Dieser Aufbau der Trennzellen und diese Zusammenschaltung der Trennzellen hat den Vorteil, daß man gegenüber Bausteinen ohne eine derartige Schaltungsanordnung wenige zusätzliche Anschlüsse am Baustein benötigt.

Zur Verwendung eines Ausführungsbeispiels des Trennzellenkonzepts sind fünf zusätzliche externe Bausteinanschlüsse erforderlich: Für die Steuerung der Trennzellen zwei Steuersignale, für den Ein- bzw. Ausgang jeweils ein Anschluß und für ein Testtaktsignal ebenfalls ein Anschluß.

In Sonderfällen läßt sich diese Anzahl zusätzlicher Anschlüsse reduzieren. Ist z.B. die Trennzellenkette mit einem Testbus (Scan-Path) verkettet, so ist nur ein zusätzlicher externer Bausteinanschluß zu den Anschlüssen des Testbusses für die Ansteuerung der Trennzellen erforderlich. Trennzellen, über die den analogen Schaltkreisen Testsignale zugeführt werden, können vorteilhafterweise am Ausgang ein Latch aufweisen, das die in der Trennzelle gespeicherte Information erst dann den Eingängen der analogen Schaltkreise anbietet, wenn alle einzugebenden Testsignale in den Trennzellen verfügbar sind. Damit wird vermieden, daß durch das Durchschieben von Signalen durch die Trennzellen im Schiebebetrieb an den Eingängen der analogen Schaltkreise sich ändernde Signale auftreten, die die analogen Schaltkreise in unerwünschter Weise beeinflussen würden. Mit Hilfe des Latch wird also erreicht, daß im seriellen Betrieb der Trennzellen keine sich ändernden Signale an den Eingängen der analogen Schaltkreise auftreten, vielmehr der bisherige Zustand aufrechterhalten wird, und erst dann, wenn die den analogen Schaltkreisen im Testbetrieb zuzuführenden Signale in den Trennzellen gespeichert sind, im Parallelbetrieb diese Signale den analogen Schaltkreisen angeboten werden.

Bei der Zufuhr von Testsignalen zu den Digitalschaltkreisen ist eine solche Maßnahme nicht erforderlich, da der digitale Block während des Schiebebetriebes der Trennzellen nicht getaktet werden muß. Die im Schiebebetrieb an den Eingängen der Digitalschaltkreise auftretenden Signaländerungen können somit die digitalen Schaltkreise nicht beeinflussen.

Eine weitere vorteilhafte Weiterbildung der Erfindung besteht darin, daß in die Leitungen, die zu den analogen Schaltkreisen führen, zusätzlich Testmultiplexer eingefügt werden, über die die Eingangssignale der analogen Schaltkreise im Testbetrieb direkt zu den äußeren Anschlüssen des Bausteins bzw. bei Abnahme von Testsignalen an Ausgängen der analogen Schaltkreise die Testsignale direkt zu äußeren Anschlüssen geführt werden. Als äußere Anschlüsse werden dabei die bereits vorhandenen Anschlüsse des Bausteins verwendet, die im Normalbetrieb direkt mit den digitalen Schaltkreisen verbunden sind. Durch diese Maßnahme ist es möglich, die analogen Schaltkreise mit einer maximalen Testerfrequenz zu betreiben. Werden die Testsignale über die Trennzellen im Schiebebetrieb zugeführt bzw. abgenommen, läuft der Testbetrieb mit einer geringeren Testerfrequenz ab.

Weiterbildungen der Erfindung ergeben sich aus den Unteransprüchen.

Anhand von Ausführungsbeispielen, die in den Figuren dargestellt sind, wird die Erfindung weiter erläutert. Es zeigen:

Figur 1 ein Blockschaltbild des Bausteins mit einer Testeinrichtung,

Figur 2 ein in einen Analogblock und einen Digitalblock aufgeteilten Baustein unter Verwendung der Schaltungsanordnung zur Zufuhr und Abnahme von Testsignalen,

Figur 3 eine erste Ausbildung der Trennzellen,

Figur 4 eine zweite Realisierung der Trennzellen,

Figur 5 den Stromlaufplan der Trennzelle nach Figur 3,

Figur 6 den Stromlaufplan der Trennzelle nach Figur 4.

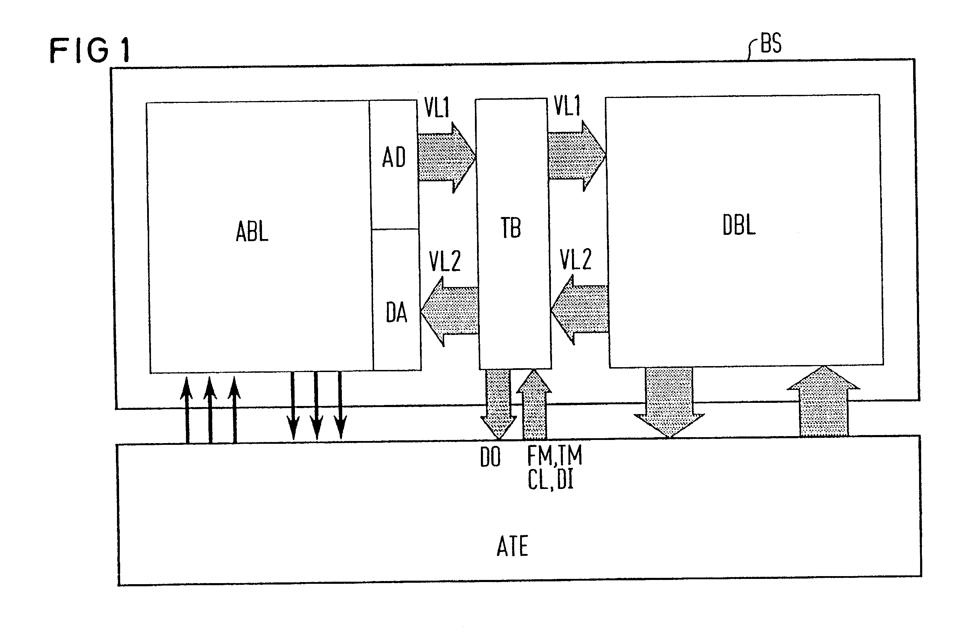

Aus Figur 1 ergibt sich eine schematische Darstellung eines zu prüfenden Bausteins BS, der mit Hilfe einer Testeinrichtung ATE getestet werden soll. Der Baustein BS weist die Besonderheit auf, daß auf ihm neben digitalen Schaltkreisen auch analoge Schaltkreise angeordnet sind. Bei der Prüfung ist es dabei zweckmäßig, die digitalen Schaltkreise in einem Digitalblock DBL zusammenzufassen, ebenso die analogen Schaltkreise in einem Analogblock ABL. Im Normalbetrieb sind die analogen Schaltkreise und digitalen Schaltkreise miteinander verbunden, um Signale auszutauschen. Die Umwandlung von analogen Signalen in digitale Signale können z.B. mit Hilfe von Analog-Digital bzw. Digital-Analogwandlern durchgeführt werden, die dem Analogblock ABL zugeordnet werden. Diese Schaltkreise sind mit AD bzw. DA in Figur 1 bezeichnet. In Figur 1 ist weiterhin dargestellt, daß die die analogen Schaltkreise mit den digitalen Schaltkreisen verbindenden Leitungen mit VL1, die die digitalen Schaltkreise mit den analogen Schaltkreisen verbindenden Leitungen mit VL2 bezeichnet sind.

Beim Testen der analogen Schaltkreise bzw. der digitalen Schaltkreise ist es vorteilhaft, wenn die Prüfung des Digi talblockes DBL bzw. des Analogblockes ABL getrennt durchgeführt werden kann. Dann aber muß gewährleistet sein, daß die Verbindungsleitungen VL zwischen dem Analogblock und dem Digitalblock unterbrochen sind. Dazu wird in diese Verbindungsleitungen VL ein sog. Trennbus TB eingefügt, durch den die Verbindungsleitungen VL1 und VL2 unterbrechbar sind.

Es ist zweckmäßig, über diesen Trennbus TB auch die Testsignale den Blöcken zuzuführen bzw. die von den Blöcken abgegebenen Testsignale wieder abzunehmen. Die Testsignalanschlüsse in Figur 1 sind beispielhaft mit DO (Ausgang) und mit DI (Eingang) bezeichnet. Zur Steuerung des Trennbusses TB können zwei Steuersignale und ein Testtaktsignal vorgesehen werden, die in Figur 1 mit FM und CL bezeichnet sind. Die zusätzlich zwischen den analogen Schaltkreisen bzw. den digitalen Schaltkreisen und äußeren Anschlüssen des Bausteins BS bestehenden Verbindungen müssen selbstverständlich beim getrennten Testen nicht unterbrochen werden.

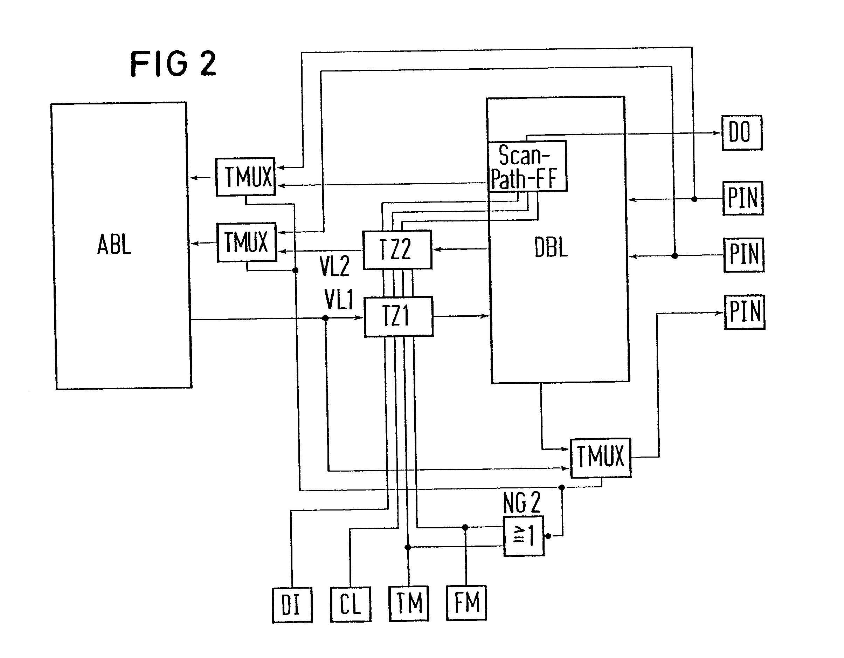

Zur Unterbrechung der Leitungen VL sind im Trennbus TB sog. Trennzellen TZ angeordnet, die sich im Prinzip aus Figur 2 ergeben. Im Ausführungsbeispiel der Figur 2 sind nur wenige Verbindungsleitungen zwischen dem Analogblock und dem Digitalblock vorgesehen, es ist selbstverständlich, daß die Anzahl auch sehr viel höher sein kann. Die Trennzellen TZ sind zweckmäßigerweise so gestaltet, daß sie die Verbindungen VL unterbrechen können bzw. die Verbindungen im Normalbetrieb so herstellen, daß bei dieser Betriebsart die Funktion des Bausteins, abgesehen von einer geringen Signalverzögerung, nicht beeinflußt ist. Weiterhin sind die Trennzellen TZ so ausgeführt, daß sie zu Schieberegistern zusammenschaltbar sind und damit im Schiebebetrieb die Testsignale in den Trennbus hineingeschoben werden können bzw. die von den Blöcken übernommenen Signale aus dem Baustein herausgeschoben werden können. Auf diese Weise ist die Anzahl der zusätzlichen äußeren Anschlüsse (PIN) für den Testbetrieb gering. Aus Figur 2 ist zu entnehmen, daß zwei äußere Anschlüsse (PIN) für Steuersignale FM und TM, ein äußerer Anschluß (PIN) für ein Taktsignal CL, ein äußerer Anschluß für die Eingabe von Testsignalen DI notwendig ist. Unter der Voraussetzung, daß im Digitalblock DBL ein Testbus (Scan Path) angeordnet ist, wie es in Figur 2 angedeutet ist, können die Testsignale über diesen Scan Path und dessen äußeren Anschluß DO zum Ausgang am Baustein 85 übertragen werden. In diesem Fall müssen der Testtakt CL und das Steuersignal TM des Testbusses (Scan-Path) für den Trennbus verwendet werden. Ist ein derartiger Prüfbus nicht vorgesehen, dann ist auch für die von den Blöcken abgegebenen Testsignalen ein zusätzlicher äußerer Anschluß (PIN) erforderlich.

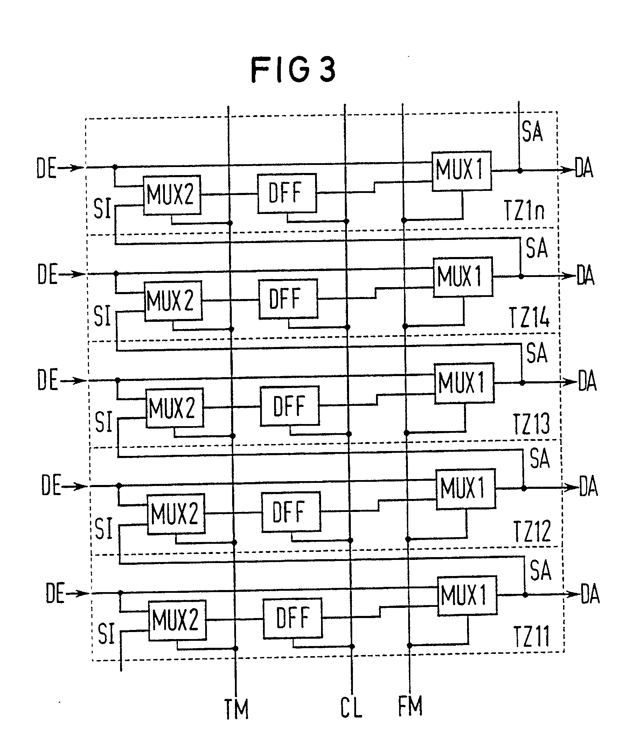

Die Trennzellen TZ1 und TZ2 können gemäß Figur 3 aufgebaut sein. Jede Trennzelle TZ besteht aus zwei Multiplexern MUX und einem Speicherelement DFF, z.B. einem D Flipflop. Die Trennzelle TZ weist einen ersten Dateneingang DE auf, der mit dem Analogblock bzw. dem Digitalblock verbunden ist. Weiterhin weist die Trennzelle einen ersten Datenausgang DA auf, der ebenfalls mit dem Analogblock bzw. Digitalblock verbunden ist. Über den ersten Multiplexer MUXI, der in die Leitung VL eingefügt ist, kann somit der Dateneingang DE mit dem Datenausgang DA unmittelbar verbunden werden, was im Normalbetrieb der Fall ist.

Der erste Dateneingang DE ist weiterhin mit einem zweiten Multiplexer MUX2 verbunden, an dem zusätzlich ein zweiter Dateneingang SI angeschlossen ist. Der zweite Multiplexer MUX2 liegt in Serie mit dem Speicherelement DFF. Die Serienschaltung aus MUX2 und DFF ist mit ihrem Ausgang an den ersten Multiplexer MUX1 angeschlossen. Durch entsprechende Einstellung des zweiten Multiplexers MUX2 kann somit entweder das am ersten Dateneingang DE anliegende Signal in das Speicherelement DFF übernommen werden oder das am zweiten Dateneingang 51 anliegende Signal. Mit Hilfe des ersten Multiplexers MUX1 ist es möglich, entweder den ersten Dateneingang DE direkt mit dem ersten Datenausgang DA zu verbinden oder das Speicherelement DFF mit dem ersten Datenausgang DA. Somit ist es möglich, entweder das am ersten Dateneingang DE anlie gende Signal in das Speicherelement DFF zu übernehmen oder das im Speicherelement DFF gespeicherte Signal an den ersten Datenausgang DA weiterzugeben.

Zweckmäßig ist es, daß die Trennzellen TZ zu einem Schieberegister zusammengeschaltet werden können. Dazu weist jede Trennzelle TZ einen zweiten Ausgang SA auf, der jeweils mit dem zweiten Dateneingang SI einer anderen Trennzelle verbunden ist. Dem zweiten Dateneingang SI einer ersten Trennzelle, z.B. der Trennzelle TzlI können dabei die Signale von einem äußeren Anschluß zugeführt werden bzw. von dem zweiten Datenausgang einer Trennzelle, z.B. der Trennzelle TZ1n können Testsignale an einen äußeren Anschluß des Bausteins abgegeben werden.

Ob die Trennzellen TZ im Normalbetrieb oder im Testbetrieb, da bei im Parallelbetrieb oder im Schiebebetrieb arbeiten, kann mit Hilfe von zwei Steuersignaien TM und FM eingestellt werden. Das Steuersignal TM wird dabei den zweiten Multiplexern zugeführt, das Steuersignal FM den ersten Multiplexern. Wenn das Steuersignal FM seinen einen Wert annimmt, dann sind z.B. die Multiplexer MUX1 in der in Figur 3 dargestellten Lage. Damit ist der erste Dateneingang DE mit dem ersten Datenausgang verbunden und die Verbindungsleitungen VL sind geschlossen. Der Baustein arbeitet im Normalbetrieb. Wenn das Steuersignal FM einen anderen Wert einnimmt, dann verbindet der erste Multiplexer MUX1 das Speicherelement DFF mit den Datenausgängen.

Wenn das Steuersignal TM seinen einen Wert einnimmt, z.B. den, der in Figur 3 dargestellt ist, dann kann das am zweiten Dateneingang SI anliegende Signal in das Speicherelement DFF übernommen werden. Der Zeitpunkt wird durch das Taktsignal CL festgelegt. Nimmt das Steuersignal TM seinen anderen Wert an, dann ist der erste Dateneingang DE mit dem Speicherelement DFF verbunden und das am ersten Dateneingang DE anliegende Signal kann in das Speicherelement DFF bei Auftreten des Taktsignales CL übernommen werden. Somit ist es möglich, die von den Blöcken BL abgegebenen Signale auf der Leitung VL in das Speicherelement DFF zu übernehmen oder die am zweiten Dateneingang anliegenden Signale SI.

Durch entsprechende Wahl der Steuersignale TM und FM können nun die Trennzellen TZ in Serie geschaltet werden und damit im Schiebebetrieb arbeiten. Dazu ist es erforderlich, daß das Steuersignal FM den ersten Multiplexer MUX1 dazu veranlaßt, die Verbindung zwischen dem speichernden Element DFF mit dem Ausgang herzustellen. Jetzt kann an dem Dateneingang SI der Trennzelle TZ11 von außen ein Testsignal zugeführt werden, das in Abhängigkeit der Taktsignale CL durch das Schieberegister bis zur Trennzelle TZ1n geschoben werden kann. Wenn die Speicherelemente DFF der Trennzelle geladen sind, kann durch Änderung der Steuersignale TM und FM im Parallelbetrieb die in den Speicherelementen DFF gespeicherten Signale über den ersten Ausgang DA zu den Blöcken übertragen werden. Umgekehrt ist es möglich, durch Verbindung des Speicherelementes DFF mit dem ersten Dateneingang DE mit Hilfe des Steuersignales TM die an den Ausgängen der Blöcke abgegebenen Testsignale in die Speicherelemente DFF zu übertragen und anschließend durch eine neue Einstellung der Steuersignale TM und FM die im Parallelbetrieb in die Speicherelemente DFF übernommenen Testsignale im Schiebebetrieb aus dem Trennbus zu einem äußeren Anschluß zu schieben. In diesem Falle würden dann z.B. am zweiten Ausgang SA der Trennzelle TZ1n in Serie die von den Blöcken abgegebenen Signale zu einem äußeren Anschluß übertragen werden.

Die Trennzellen können somit in drei Betriebsarten arbeiten:

a) Systemmodus: Der erste Dateneingang der Trennzelle wird mit dem ersten Datenausgang verbunden, die Trennzelle verhält sich transparent.

b) Lademodus: Die Trennzelle übernimmt Daten von Ausgängen der Schaltkreise in das Speicherelement.

c) Schiebemodus: Durch Verkettung der Trennzellen zu einem Schieberegister können die im Lademodus gespeicherten Daten aus dem Trennbus hinausgeschoben und gleichzeitig externe Daten in den Trennbus eingeschoben werden.

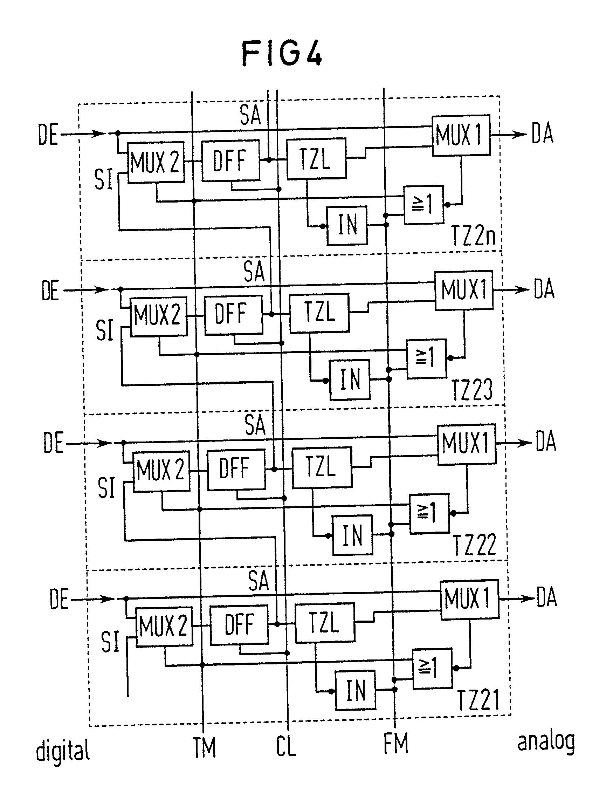

Wenn entsprechend Figur 3 ausgeführte Trennzellen in Leitungen liegen, die von digitalen Schaltkreisen zu analogen Schaltkreisen führen, und diese Trennzellen im Schiebebetrieb arbeiten, dann wird an den Eingängen der analogen Schaltkreise ein Bitstrom vorbeigeführt, der die analogen Schaltkreise beeinflussen kann. Um dies zu verhindern, kann die Trennzelle TZ1 nach Figur 3 entsprechend Figur 4 zur Trennzelle TZ2 weitergebildet sein. Jetzt ist am Ausgang der Serienschaltung aus dem zweiten Multiplexer MUX2 und dem Speicherelement DFF ein weiteres speicherndes Element TZL angeschaltet, z.B. ein Latch. Dieses Element TZL ist dann mit dem ersten Multiplexer MUXI verbunden. Mit dem Element TZL kann verhindert werden, daß im Schiebemodus die in den Speicherelementen DFF gespeicherten Signale über den ersten Multiplexer MUX1 zum ersten Datenausgang DA gelangen. Somit können Signale durch die Trennzelle TZ2 hindurchgeschoben werden, ohne daß sich der Zustand an den ersten Datenausgängen DA ändert. Dieser Zustand wird durch den Inhalt der Elemente TZL festgelegt und kann mit Hilfe der Steuersignale TM und FM dann geandert werden, wenn der Schiebebetrieb beendet ist, d.h. alle Speicherelemente DFF ihre Signale gespeichert haben. Jetzt kann im Parallelbetrieb über die Zelle TZL das in den Speicherelementen DFF gespeicherte Signal zu den entsprechenden Datenausgängen DA übergeben werden. Zur entsprechenden Steuerung des ersten Multiplexers MUX1 und des Elementes TZL werden die Steuersignale TM und FM herangezogen und diese verknüpft durch ein NOR-Glied NG1 dem ersten Multiplexer zugeführt. Das Element TZL wird durch das invertierte Steuersignal FM angesteuert.

Die Einstellung der Steuersignale kann z.B. folgendermaßen sein:
Wenn TM und FM beide "low" sind, dann ist der Multiplexer MUX1 in einer Stellung, die die Verbindungsleitung VL schließt, d.h. das Signal am ersten Dateneingang DE erscheint am ersten Datenausgang DA.

Wenn das Steuersignal TM low ist und das Steuersignal FM high, dann werden die Signale mit steigender Taktflanke am ersten Dateneingang DE in die Speicherelemente DFF übernommen.

Sind die Steuersignale TM und FM beide high, dann wird im Schiebebetrieb gearbeitet und die an den zweiten Dateneingänge SI anliegenden Signale zu den zweiten Datenausgängen SA weitergeschoben.

Wenn schließlich das Steuersignal TM high und das Steuersignal FM low ist, dann wird bei der Trennzelle nach Figur 4 das in den Speicherelementen DFF gespeicherte Signal über die Elemente TZL zum ersten Datenausgang DA übertragen. Da, wie Figur 4 zeigt, der zweite Datenausgang SA vom ersten Datenausgang DA über das Element TZL getrennt ist, ist der Schiebebetrieb ohne Beeinflussung des ersten Datenausganges DA möglich.

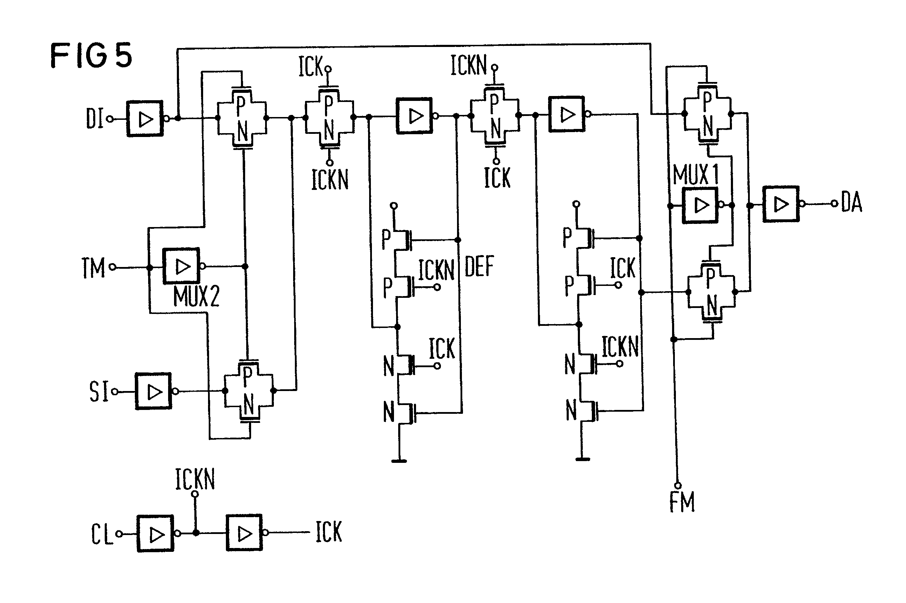

Eine Realisierung der Trennzelle TZ1 nach Figur 3 zeigt Figur 5. Die Figur 5 ist selbsterklärend und braucht nicht weiter erläutert zu werden.

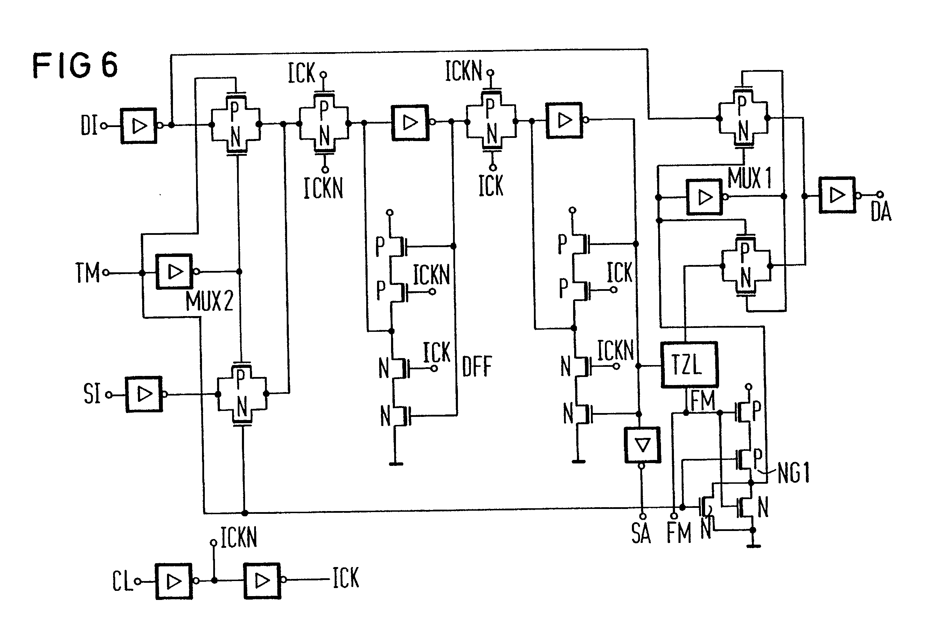

Figur 6 zeigt wie die Trennzelle TZ2 nach Figur 4 realisiert sein kann. Sie entspricht im wesentlichen der Figur 5, zusätzlich ist das Element TZL und das NOR-Glied NG1 vorgesehen. Der Inverter nach IN nach Figur 4 ist im Element TZL realisiert.

Der Aufbau des Elementes TZL, z.B. als Latch ist bekannt und braucht nicht weiter dargestellt zu werden.

Wie aus den Figuren 3 und 4 erkennbar ist, wird die Schnelligkeit, mit der Testsignale zu dem Analogblock bzw. Digitalblock übertragen werden können bzw. die von den Blöcken abgegebenen Testsignale zu den äußeren Ausgängen geführt werden können durch die Schnelligkeit des Schiebebetriebes festgelegt. Die Trennzellen werden dabei mit der Testfrequenz am Anschluß GL betrieben. Soll die Testfrequenz erhöht werden, z.B. beim Prüfen des Analogblockes ABL, dann ist es zweckmäßig, gemäß Figur 2 Testmultiplexer TMUX vorzusehen. Durch den Einbau von Testmultiplexern TMUX kann der Analogblock ABL von gemischt analog-digitalen VLSI Schaltungen direkt von außen eingestellt und beobachtet werden. Das heißt es ist nicht mehr notwendig, die Signale über den Digitalteil zu führen. Es ist dann keine Schiebeoperation erforderlich, daher kann der Analogteil bis zur maximalen Testfrequenz betrieben werden. Die intern analogen Ein- bzw. Ausgänge werden mit externen Anschlüssen (PIN) über die Testmultiplexer TMUX entsprechend Figur 2 direkt verbunden.

Der Analogteil kann in diesem Fall im Testmodus vollständig über externe Anschlüsse (PIN) angesprochen werden. Diese Lösung setzt voraus, daß mindestens soviele externe digitale Ein- bzw. Ausgänge (PIN) verfügbar sind wie intern analoge Ein- bzw. Ausgänge des Analogblocks. Diese Bedingung wird in den praktischen Fällen erfüllt sein.

Für den Test des Digitalblocks DBL werden dann wie bisher auch Trennzellen TZ verwendet und zwar Trennzellen TZ1 bei Leitungen VL1, die vom Analogblock zum Digitalblock führen, und Trennzellen TZ2 bei Leitungen VL2, die vom Digitalblock zum Analogblock führen.

Die Ansteuerung der Testmultiplexer TMUX kann mit Hilfe der Steuersignale TM und FM erfolgen, die durch ein NOR-Glied NG2 verknüpft werden. Diese Verknüpfung kann folgendermaßen erfolgen:

Wenn TM und FM beide low sind, ist der Ausgang des NOR-Gliedes NG2 high und damit befinden wir uns im transparent mode, d.h. im Normalbetrieb. Die äußeren Anschlüsse (PIN) sind direkt mit den digitalen Schaltkreisen des Digitalblockes DBL verbunden. Wenn die Steuersignale TM und FM unterschiedlich sind oder beide high sind, gibt das NOR-Glied NG2 ein low Signal ab und damit werden die Testmultiplexer TMUX im Testbetrieb betrieben, d.h. sie verbinden den Analogblock ABL mit den äußeren Anschlüssen (PIN), die normalerweise mit den äußeren Anschlüssen (PIN), die normalerweise mit den digitalen Schaltkreisen des Digitalblockes DBL verbunden sind.

Bei der Prüfung des Digitalblockes DBL und des Analogblockes ABL werden somit digitale Trennzellen verwendet, über die rein digitale Signale geführt werden. Die Testsignale, die von den Blöcken abgegeben werden, können dabei über die Trennzellen von außen beobachtet werden bzw. die Testsignale können von außen über die Trennzellen den Blöcken zugeführt werden. Bei der Ausführungsform mit den Testmultiplexern, können dem Analogblock ABL Testsignale von außen parallel zugeführt werden und Testsignale von Ausgängen des analogen Blockes direkt nach außen zu den äußeren Anschlüssen (PIN) übertragen werden.

**Ansprüche**

1. Schaltungsanordnung zur Zufuhr und Abnahme von Testsignalen bei der Prüfung eines analoge und digitale Schaltkreise aufweisenden Bausteins mit folgenden Merkmalen:
   a) in analoge und digitale Schaltkreise verbindenden Leitungen (VL1, VL2) sind jeweils die Leitungen unterbrechende, ein Speicherelement aufweisende Trennzellen (TZ) eingefügt, die pro Zelle
   a1) einen ersten Dateneingang (DE) und einen ersten Datenausgang (DA) zur Verbindung mit der zugeordneten Leitung an der Unterbrechungsstelle aufweisen,
   a2) einen weiteren Dateneinang (SI) und einen weiteren Datenausgang (SA) aufweisen, wobei der weitere Dateneingang mit einem weiteren Datenausgang einer anderen Zelle oder mit einem äußeren Signaleingang (PIN) verbunden ist und der weitere Datenausgang mit einem weiteren Dateneingang einer weiteren Zelle oder mit einem äußeren Signalausgang verbunden ist,
   b) die Trennzellen sind so steuerbar, daß
   b1) die Unterbrechungsstelle in der Leitung überbrückt ist,
   b2) das am ersten oder zweiten Dateneingang anliegende Signal im Speicherelement (DFF) gespeichert wird,
   b3) das im Speicherelement (DFF) gespeicherte Signal an einem Datenausgang abgegeben wird,
   b4) die am äußeren Signaleingang anliegenden Signale in die Trennzellen geschoben werden.

2. Schaltungsanordnung nach Anspruch 1, **gekennzeichnet** durch eine Trennzelle aus
   - einem ersten Multiplexer (MUX1), dessen einer Eingang mit dem ersten Dateneingang (DE), dessen Ausgang mit dem ersten Datenausgang (DA) verbunden ist und der von einem ersten Steuersignal (FM) gesteuert wird,
   - einer Serienschaltung aus einem durch ein zweites Steuersignal (TM) steuerbaren zweiten Multiplexer (MUX2) und dem Speicherelement (DFF), bei der der eine Eingang des zweiten Multiplexers mit dem ersten Dateneingang (DE), der andere Eingang mit dem zweiten Dateneingang (SI) und der Ausgang mit dem anderen Eingang des ersten Multiplexers (MUX1) verbunden ist.

3. Schaltungsanordnung nach Anspruch 2, dadurch **gekennzeichnet**, daß die Serienschaltung am Ausgang des Speicherelementes (DFF) zusätzlich ein Element (TZL) aufweist, durch das verhinderbar ist, daß das im Speicherelement (DFF) gespeicherte Signal zum ersten Datenausgang (DA) gelangt.

4. Schaltungsanordnung nach Anspruch 3, dadurch **gekennzeichnet**, daß Trennzellen mit erweiterter Serienschaltung in Leitungen (VL2) angeordnet sind, deren Übertragungsrichtung vom digitalen Schaltkreis zum analogen Schaltkreis führt.

5. Schaltungsanordnung nach einem der vorhergehenden Ansprüche, dadurch **gekennzeichnet**, daß Testmultiplexer (TMUX) vorgesehen sind, die in den Verbindungsleitungen vom Digitalblock (DBL) zum Analogblock (ABL) liegen und die einerseits die Leitung (VL2), andererseits einen äußeren mit dem Digitalblock (DBL) verbundenen äußeren Anschluß (PIN) an den Analogblock (ABL) anschalten.

6. Schaltungsanordnung nach Anspruch 5, dadurch **gekennzeichnet**, daß die vom Analogblock (ABL) zum Digitalblock (DBL) führenden Leitungen (VL1) mit Testmultiplexern (TMUX) verbunden sind, der die Leitung (VL1) oder eine vom Digitalblock (DBL) zu einem äußeren Anschluß (PIN) führende Leitung mit dem äußeren Anschluß (PIN) verbindet.

7. Schaltungsanordnung nach Anspruch 6,
dadurch **gekennzeichnet,**
daß die Steuerung der Testmultiplexer (TMUX) durch die Steuersignale (TM, FM) erfolgt.

# FIG 1

EP 0 408 970 A2

# FIG 2

EP 0 408 970 A2

# FIG 3

# FIG 4

FIG 5

DA

MUX1

FM

ICK

ICKN

P P N N

ICKN

ICK

P N

ICKN DEF

ICKN

ICK

P P N N

ICK

ICKN

P N

DI

MUX2

TM

SI

ICKN

ICK

CL

# FIG 6

EP 0 408 970 A2